(19) Europäisches Patentamt
European Patent Office
Office européen des brevets

(11) **EP 1 879 240 A2**

(12) **EUROPEAN PATENT APPLICATION**

(43) Date of publication:
**16.01.2008 Bulletin 2008/03**

(51) Int Cl.:
**H01L 51/10** (2006.01)

(21) Application number: **07005965.4**

(22) Date of filing: **22.03.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **13.07.2006 JP 2006192292**

(71) Applicant: **Hitachi, Ltd.**
**Chiyoda-ku**
**Tokyo 100-8280 (JP)**

(72) Inventors:
• **Hashizume, Tomihiro**
 **Tokyo 100-8220 (JP)**
• **Fujimori, Masaaki**
 **Tokyo 100-8220 (JP)**
• **Suwa, Yuji**
 **Tokyo 100-8220 (JP)**
• **Arai, Tadashi**
 **Tokyo 100-8220 (JP)**

(74) Representative: **Strehl Schübel-Hopf & Partner**
**Maximilianstrasse 54**
**80538 München (DE)**

(54) **Field effect transistor, organic thin-film transistor and manufacturing method of organic transistor**

(57) A method for determining the combination of the electrode and organic semiconductor with improved electron injection efficiency and hole injection efficiency in an organic TFT is provided, two types of FETs, that is, an n channel FET and a p channel FET are realized, and further, a complementary TFT (CTFT) is provided. The method for obtaining the vacuum level shift at the electrode metal/organic semiconductor interface from physical constants of constituent elements of the electrode and the organic semiconductor is provided. By changing the electrode metal through an electrochemical method, the electrodes whose electron injection and hole injection can be controlled are formed. By using these electrodes, two types of FETs such as an n channel FET and a p channel FET are realized, thereby providing a complementary TFT (CTFT).

*FIG. 1*

EP 1 879 240 A2

**Description**

## TECHNICAL FIELD OF THE INVENTION

The present invention relates to a field effect transistor (FET), an organic thin-film transistor, and a manufacturing method of an organic transistor. More particularly, it relates to a thin-film transistor (TFT) using organic semiconductor for its channel. Furthermore, it relates to a so-called CTFT (Complementary TFT) in which two types of FETs, that is, a FET whose carriers passing through its channel are electrons (n channel TFT) and a FET whose carriers are holes (p channel TFT) are connected in series and a manufacturing method thereof.

## BACKGROUND OF THE INVENTION

In a thin-type display device using an organic EL (Electro Luminescence) element and liquid crystal, a thin-film transistor (TFT) using amorphous silicon and polycrystalline silicon for its channel has been used as an element for driving pixels. At present, it is difficult to give plasticity to a TFT using amorphous silicon and polycrystalline silicon, and since vacuum apparatus is used for the manufacturing process thereof, the manufacturing cost is high in general. Therefore, for the display device as described above, in order to realize a flexible display device and reduce the manufacturing cost, a study for the purpose of forming a TFT used for a driving circuit from an organic material has been widely conducted. In the organic thin-film transistor (organic TFT), a semiconductor layer constituting a channel can be formed through a simple process such as the printing process, the spray process, or the inkjet process, and it is expected that the organic TFT can be manufactured at significantly low cost compared with a TFT using inorganic semiconductor. Further, it has the potential that a large-area, lightweight, and thin-type display and integrated circuit can be fabricated easily, and the application thereof to a liquid crystal display, an organic EL display, an IC card and others is expected. 003 For realizing the flexible display device, peripheral circuits for driving pixels also have to be flexible. As a TFT used for a circuit which drives pixels, a TFT having carrier mobility of about 10 cm$^2$/V·s or more is required, and it is confirmed that this condition is satisfied by a TFT using organic molecules with small molecular weight for its channel. In Science, 303, 1644 (2004) (Non-Patent Document 1), the carrier mobility of 15 (cm$^2$/V·s) is acquired by an organic TFT using single crystal of rubrene molecules for its channel. Also, in Applied Physics Letters, 84, 3061 (2004) (Non-Patent Document 2), the carrier mobility of 35 (cm$^2$/V·s) at room temperature for the single crystal of high-purity pentacene molecules is reported. However, for the manufacture of an organic TFT formed of low molecule whose performance can be improved easily, the vacuum deposition is used in general, and it is disadvantageous in terms of a manufacturing aspect. Meanwhile, an organic TFT formed of high molecule which is advantageous in terms of manufacturing cost is particularly low in performance as TFT and it can be applied only to the limited uses.

004 As means for solving the problems mentioned above, there is a method in which low molecule is dissolved in solvent and then applied, thereby forming a semiconductor layer for a channel. With respect to pentacene which is the most typical organic molecule to be applied to a TFT of low molecule, Journal of Applied Physics, 79, 2136 (1996)) (Non-Patent Document 3) and Journal of American Chemical Society, 124, 8812 (2002)) (Non-Patent Document 4) have reported a technology in which derivative of pentacene molecules is synthesized to increase the solubility to solvent and a thin film is formed using the resultant solution. Also, Synthetic Metals, 153, 1 (2005) (Non-Patent Document 5) describes the technology in which pentacene molecules are directly dissolved into solvent and then applied to form a thin film. Further, the Non-Patent Document 2 and Japanese Journal of Applied Physics, 43, L315 (2004) (Non-Patent Document 6) describe the procedure for dissolving pentacene molecules into organic solvent.

005 Further, in order to manufacture an organic FET at low cost by means of coating, it is desired that wires and electrodes formed of metal as well as the organic semiconductor are formed by coating. In the method for realizing it, metal is transformed into fine particles and then covered with an organic matter to give solubility to solvent, and the resultant metal ink or paste in which the fine particles are dissolved is distributed to predetermined positions by printing. Then, a process at a predetermined temperature is performed to remove the organic matter, thereby forming the metal wires and electrodes. At present, the method for forming wires by printing silver or gold paste has been established.

006 On the other hand, in a TFT using silicon, a complementary TFT (CTFT) in which two types of FETs, that is, a FET whose carriers passing through its channel are electrons (n channel TFT) and a FET whose carriers are holes (p channel TFT) are connected in series and power consumption is low has become an essential requirement for integration.

However, up till very recently, it is known that most of the organic TFTs are operated only as p type FETs. Although some causes therefor have been suggested, they remain controversial. For example, in Applied Physics, 74 (9), 1196 (2005) (Non-Patent Document 7), an example of an n channel organic FET and a p channel organic FET is described. However, different organic semiconductors are used for the n type TFT and the p type TFT realized in the Non-Patent Document 7, and economically advantageous process is not described therein. Further, the fundamental principle for forming an n type TFT and a p type TFT is not shown therein.

Japanese Patent Application Laid-Open Publication No. 2004-55654 (Patent Document 1) discloses an organic semiconductor element characterized in that a source electrode and a drain electrode are formed of different materials with different work functions. For example, as a material for a source electrode used in a p type organic semiconductor element, a material with a high work function (metals such as gold, platinum, palladium, chromium, celenium, and nickel, indium tin oxide (ITO), iridium zinc oxide (IZO), zinc oxide, and alloy thereof, zinc oxide, copper iodide, and others) is considered preferable. As a material for a drain electrode, metal or compound with a work function lower than that of a source electrode (metals such as silver, lead, tin, aluminum, calcium, and indium, alkali metal such as lithium, alkali earth metal such as magnesium and alloy thereof, and alkali metal compound and alkali earth metal compound, and others) is considered suitable. However, when an organic semiconductor material is in contact with an electrode material, since charge exchange and charge screening occur at an electrode/organic semiconductor interface in general, the types thereof (n type/p type) are not determined only by the work function of the electrodes.

In Japanese Patent Application Laid-Open Publication No. 2004-211091 (Patent Document 2), organic semiconductor polymer showing both of the electrically p type characteristic and n type characteristic is provided by introducing a unit with p type semiconductor characteristic (for example, thiophene unit) and a unit with n type semiconductor characteristic (for example, thiazole ring) into polymer main chain, and by using it, the organic semiconductor polymer for an organic thin-film transistor characterized in that the Off current is low and both characteristics can be shown is disclosed. However, even if the property of a bulk can be defined, since the electron structure at an electrode/organic semiconductor interface and at an insulator/organic semiconductor interface used in a FET cannot be determined, the characteristic of an organic TFT cannot be decided.

Japanese Patent Application Laid-Open Publication No. 2004-128028 (Patent Document 3) discloses an organic FET using the following metal oxides as a semiconductor layer, that is, the metal oxides include: metal oxides which create oxygen vacancy or interstitial metal and show high conductivity when deviating from the stoichiometric ratio (tin oxide, titanium oxide, germanium oxide, copper oxide, silver oxide, indium oxide, thallium oxide, barium titanate, strontium titanate, lanthanum chromate, tungsten oxide, europium oxide, aluminum oxide, and lead chromate); metal oxides showing the highest conductivity at the stoichiometric ratio (rhenium oxide, titanium oxide, lanthanum titanate, lanthanum nickelate, lanthanum copper oxide, ruthenium copper oxide, strontium iridate, strontium chromate, lithium titanate, iridium oxide, and molybdenum oxide); conductive metal oxides (vanadium oxide, chromium oxide, calcium ferrate, strontium ferrate, strontium cobaltate, strontium vanadate, strontium ruthenate, lanthanum cobaltate, and nickel oxide); and conductive metal oxide bronze (tungsten oxide, molybdenum oxide, tungsten bronze obtained by introducing hydrogen atom, alkali metal, alkali earth metal, or rare earth metal into the position of A of the perovskite structure of rhenium oxide where there is no atom ($M_xWO_3$), $M_xMO_3$, and $M_xReO_3$). In this case, these metal oxides are used as semiconductor materials, and are not used as electrode materials.

On the other hand, in Physical Review Letters 84 (26), 6078 (2000) (Non-Patent Document 8), a method for generally obtaining the vacuum level shift $\Delta$ at the electrode/inorganic semiconductor interface from physical constants of the constituent elements of the electrode and semiconductor is discussed. By using this vacuum level shift $\Delta$, the Schottky barrier $\Phi$ regarding the carrier (electrons and holes) injection at the electrode/inorganic semiconductor interface can be calculated, and the carrier injection rate (number of charges injected per one second) can be calculated using an appropriate carrier injection mechanism such as thermal ion excitation model. More specifically, when the carriers are electrons, the Schottky barrier $\Phi$ can be obtained from the following formula 1.

$$\Phi = \phi_M - \chi_S + \Delta \quad \text{(formula 1)}$$

In this case, the vacuum level shift $\Delta$ takes a positive value if the Shottky barrier $\Phi$ is increased when electrons are injected from the electrode to the semiconductor, $\phi_M$ is a work function of the electrode, and $\chi_S$ is the electron affinity of the semiconductor (difference between vacuum level and lower end energy of conduction band). Further, according to the Non-Patent Document 8, the Shottky barrier $\Phi$ is obtained by the following formula 2.

$$\Phi = \gamma_B (\phi_M - \chi_S) + (1 + \gamma_B) E_g/2 \quad \text{(formula 2)}$$

Here, the following formulas 3 to 5 are provided.

$$\gamma_B = 1 - e^2 d_{MS} N_B / \varepsilon_{it}(E_g + \kappa) \quad \text{(formula 3)}$$

$$\kappa = 4e^2/(\varepsilon_S d_B) - 2e^2/(\varepsilon_{it} d_{MS}) \quad \text{(formula 4)}$$

$$\varepsilon_{it} = 1/(1/(2\varepsilon_S) + 1/(2\varepsilon_M)) \quad \text{(formula 5)}$$

Here, Eg: bandgap energy of semiconductor, e: elementary charge amount of electrons, $d_{MS}$: distance between atoms constituting the electrode and semiconductor at the electrode/semiconductor interface, $N_B$: number of bonds (interatomic bonds) per unit area at the electrode/semiconductor interface, a: number of nearest neighbor atoms of constituent atoms in an interface direction at the electrode/semiconductor interface, $\varepsilon_S$: dielectric constant of semiconductor, $d_B$: interatomic distance of constituent atoms in an interface direction at the electrode/semiconductor interface, and $\varepsilon_M$: dielectric constant of the electrode. When the electrode is made of metal, since $\varepsilon_M$ is infinite, the following formula 6 is used instead of the formula 5.

$$\varepsilon_{it} \sim 2\varepsilon_S \quad \text{(formula 6)}$$

When the electrode is not made of metal, the formula 5 can be used as it is.

However, in the Non-Patent Document 8, only the application to the electrode/inorganic semiconductor interface where the interatomic bonding at the interface is mainly the chemical bonding is discussed, and the application to the electrode/organic semiconductor interface where the bonding is relatively weak is impossible.

## SUMMARY OF THE INVENTION

020 In the embodiments of the present invention, a method for determining the combination of the electrode and organic semiconductor with improved electron injection efficiency and hole injection efficiency in an organic TFT is provided. Further, two types of FETs, that is, an n channel FET and a p channel FET are realized, and also, a complementary TFT (CTFT) is provided. Furthermore, an n type TFT and a p type TFT can be realized using the same organic semiconductor, and the manufacturing method by an economically advantageous process is provided.

021 First, a method for generally obtaining the vacuum level shift $\Delta$ at the electrode metal/organic semiconductor interface from physical constants of constituent elements of the electrode and organic semiconductor by using evaluation results of electron states of some electrode metal/organic semiconductor interfaces will be provided. By using this vacuum level shift $\Delta$, electrodes whose electron injection and hole injection can be controlled are created from some electrode metals and those changed based on an electrochemical method. Two type of FETs such as an n channel FET and a p channel FET are realized by using these electrodes, and further, a complementary TFT (CTFT) is provided. Furthermore, as a method for forming an n channel FET and a p channel FET, a method for electrochemically changing an electrode surface by continuously introducing a flexible substrate on which the electrode is formed into an electrochemical tank is disclosed.

According to embodiments of the present invention, a low-power consumption type CTFT formed of organic TFTs can be manufactured, and a large-area, lightweight, and thin-type integrated circuit formed of the organic TFTs can be fabricated easily. Also, the application of the organic TFTs and organic thin-film devices to a liquid crystal display, an organic EL display, an IC card, a tag and others can be realized.

## BRIEF DESCRIPTIONS OF THE DRAWINGS

FIG. 1 is a cross-sectional view showing an example of a structure of a CTFT formed in an embodiment of the present invention;

FIG. 2A is a cross-sectional view showing a manufacturing method of a CTFT formed in an embodiment of the present invention;

FIG. 2B is a cross-sectional view showing a manufacturing method of a CTFT formed in an embodiment of the present invention;

FIG. 2C is a cross-sectional view showing a manufacturing method of a CTFT formed in an embodiment of the present invention;

FIG. 2D is a cross-sectional view showing a manufacturing method of a CTFT formed in an embodiment of the present invention;

FIG. 2E is a cross-sectional view showing a manufacturing method of a CTFT formed in an embodiment of the present invention;

FIG. 2F is a cross-sectional view showing a manufacturing method of a CTFT formed in an embodiment of the present invention; and

FIG. 3 is a schematic diagram showing an example of manufacturing apparatus for successively performing surface treatment for electrodes of the CTFT in an embodiment of the present invention.

## DESCRIPTIONS OF THE PREFERRED EMBODIMENTS

(First Embodiment)

In this embodiment, the discussion of the Non-Patent Document 8 is extended, and a method for obtaining the Schottky barrier $\Phi$ at the electrode/organic semiconductor interface from physical constants of the constituent elements of the electrode and semiconductor is provided. As the combinations of an electrode and organic semiconductor, there are hydrogen-terminated silicon surface/polythiophene polymer, gold/pentacene crystal, gold/various thiol monomolecular film, silver/ various thiol monomolecular film, and others, and electron states thereof are examined by the logical computation by first principle calculation and the electron state measurement using a scanning tunnel microscope. As a result, it can be found that the Schottky barrier $\Phi$ can be estimated using the following formulas 7 to 11.

More specifically, when the carriers are electrons, the Schottky barrier $\Phi$ can be obtained by the formula 7.

$$\Phi = \gamma_B \ (\phi_M - \chi_S) + (1 + \gamma_B)E_g/2 \quad \text{(formula 7)}$$

Here, the following formulas 8 to 10 are provided.

$$\gamma_B = 1 - \alpha_{MS}e^2 d_{MS}N_B/\varepsilon_{it}(E_g + \kappa) \quad \text{(formula 8)}$$

$$\kappa = a\alpha_B e^2/(\varepsilon_S d_B) - 2\alpha_{MS}e^2/(\varepsilon_{it}d_{MS}) \quad \text{(formula 9)}$$

$$\varepsilon_{it} = 1/(1/(2\varepsilon_S) + 1/(2\varepsilon_M)) \quad \text{(formula 10)}$$

In particular, when the electrode is made of metal, the following formula 11 is provided.

$$\varepsilon_{it} \sim 2\varepsilon_S \quad \text{(formula 11)}$$

Here, $\phi_M$: work function of the electrode, $\chi_S$: electron affinity of the organic semiconductor, Eg: bandgap energy of the organic semiconductor, $\alpha_{MS}$: interaction correction coefficient between electrode and organic semiconductor, e: elementary charge amount of electrons, $d_{MS}$: interatomic distance between the electrode and organic semiconductor at the electrode/organic semiconductor interface, $N_B$: number of bonds per unit area at the electrode/organic semiconductor interface (chemical bond or other interaction), a: number of nearest neighbor atoms of electrode constituent atoms in an interface direction at the electrode/organic semiconductor interface, $\alpha_B$: interaction correction coefficient between electrode constituent elements in an interface direction at the electrode/organic semiconductor interface, $\varepsilon_S$: dielectric constant of organic semiconductor, $d_B$: interatomic distance of electrode constituent atoms in an interface direction at the electrode/organic semiconductor interface, and $\varepsilon_M$: dielectric constant of the electrode (when the electrode is made of metal, $\varepsilon_M$ is infinite). $\alpha_{MS}$ and $\alpha_B$ are correction coefficients depending on the types of the interactions and relating to the interaction between the electrode and the organic semiconductor and between electrode constituent elements. It can be understood that the good estimation of the Schottky barrier $\Phi$ can be acquired when a value of about $\alpha = 1$ is

used for metal bonding and ion bonding and covalent bonding of inorganic semiconductor, an value of about $\alpha$ = 0.7 to 1 is used for Van der Waals' forces (intermolecular force) with small interaction in general, and a value of about $\alpha$ = 0.4 to 1 is used for the interaction where a certain movement of charges is expected such as the case of silver and pentacene.

It can be understood by the above-described estimation method that examples of the combination where two types of FETs of an n channel FET and a p channel FET can be realized by using one type of electrode and one type of organic semiconductor are as follows, that is, (1) electrode: silver and silver oxide and organic semiconductor: pentacene crystal (single crystal or polycrystal), (2) electrode: silver and silver sulfide (or thiol molecules in which carbon hydride molecules are bonded with sulfur atoms) and organic semiconductor: pentacene crystal (single crystal or polycrystal), (3) electrode: titanium, titanium oxide and organic semiconductor: pentacene crystal (single crystal or polycrystal), and (4) electrode: titanium carbide, titanium oxide and organic semiconductor: pentacene crystal (single crystal or polycrystal).

(Second Embodiment)

In this embodiment, an example of CTFT according to the present invention will be disclosed.

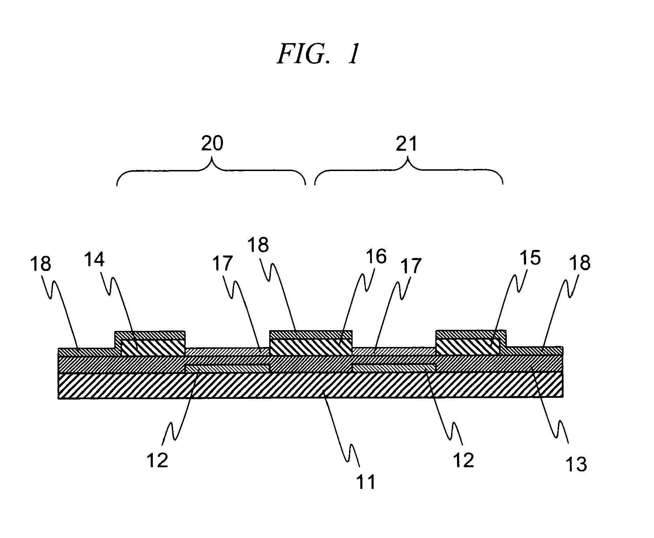

FIG. 1 is a cross-sectional view schematically showing a structure of a CTFT according to the present invention. In FIG. 1, an organic semiconductor thin film 17 is a polycrystalline pentacene thin film made of pentacene crystal grains in this embodiment. The CTFT is composed of a source electrode 14 and a source electrode 15, an organic semiconductor thin film 17, a common drain electrode 16, and two gate electrodes 12. The CTFT has a structure where an n channel FET 20 and a p channel FET 21 are connected in series. In this embodiment, the source electrode 15 functions as a ground electrode and the source electrode 14 functions as an operation voltage applying electrode, and common voltage signals are inputted to the two gate electrodes 12 and the drain electrode 16 functions as an output electrode. A liquid repellent region 18 is a region with high liquid repellency, and by making the interface between the organic semiconductor thin film 17 and an insulating film 13 in a lyophilic state (low liquid repellency) in a previous step of forming the organic semiconductor thin film 17, the organic semiconductor thin film 17 can be formed spontaneously.

In FIG. 1, the insulating film 13 is formed after forming the gate electrode 12 on a substrate 11. The liquid repellent region 18 and the lyophilic region (interface between the organic semiconductor thin film 17 and the insulating film 13) described with reference to FIG. 1 are formed on the insulating film 13. This lyophilic region is formed in a self-aligned manner so as to be placed at a position corresponding to the gate electrode 12. After forming the organic semiconductor thin film 17 by using the difference in lyophilicity between the liquid repellent region 18 and the lyophilic region, the source electrode 14, the source electrode 15, and the drain electrode 16 are formed.

In the present invention, the source electrode 14 and the source electrode 15 are first made of the same material (silver in this embodiment), and then, the source electrode 14 is selectively oxidized, thereby forming the source electrode 14 (silver oxide electrode) and the source electrode 15 (silver electrode).

(Third Embodiment)

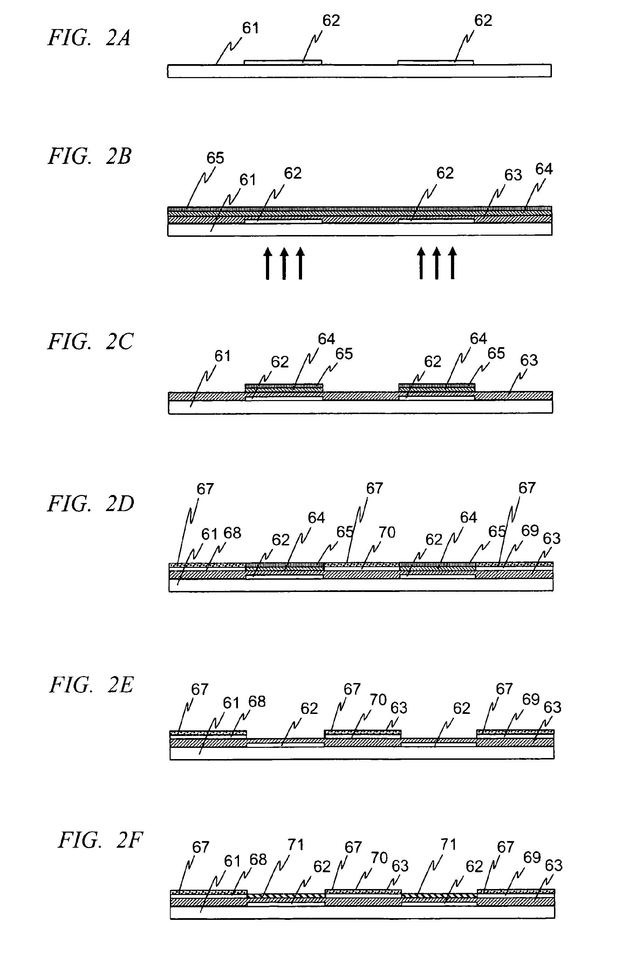

In this embodiment, an example of a manufacturing method of a CTFT formed by the present invention will be disclosed. FIG. 2A to FIG. 2F are sectional views showing an example of a manufacturing method of a CTFT formed by the present invention. In this embodiment, a manufacturing method of an organic thin-film CTFT according to the present invention will be described, in which a material with plasticity is used and printing process and coating process are employed instead of lithography. FIG. 2A to 2F are cross-sectional views for describing the manufacturing method specifically.

As shown in FIG. 2A, gate electrodes 62 are printed using conductive ink on a plastic substrate 61. Since the gate electrodes 62 are formed by baking the printed ink, it is necessary to pay attention to the softening temperature of the substrate 61 because a plastic substrate is used for the substrate 61. In this embodiment, since a high heat-resistant transparent polyimide sheet with a thickness of 100 $\mu$m is used for the substrate 61, the baking temperature can be increased up to about 250°C. Accordingly, the substrate can bear the baking temperature of 120°C which is required in the case of using ultrafine silver particles diffused solution for the conductive ink.

Polymethyl methacrylate (PMMA) is spin-coated on the substrate 61 and the gate electrodes 62 and then dried sufficiently, thereby forming a gate insulating film 63. In this case, the drying is performed at 100°C for 10 minutes by using a hot plate. Further, a photosensitive thin film 64 is formed thereon. In this embodiment, a positive resist is spin-coated to form a film with a thickness of 100 nm.

Subsequently, a liquid repellent pattern is formed so as to form a source electrode 68, a source electrode 69, and a drain electrode 70. As a liquid repellent film 65, alkyl-fluoride-based silane coupling agent (DAIKIN INDUSTRIES, Ltd., product name: Optool) diluted by perfluorooctane to 0.1 wt% is spin-coated, and ultraviolet rays are irradiated from the plastic substrate 61 side by using a mercury lamp as illustrated by arrows in FIG. 2B. The ultraviolet ray necessary for the exposure of the photosensitive thin film 64 used in this embodiment is required to have a wavelength of 365 nm, that is, it is an i-ray. Therefore, in order to prevent the laminated gate insulating film 63 (polymer film-polymethyl methacrylate (PMMA) film) from being damaged, the ultraviolet ray with a wavelength of 300 nm or less is desirably cut by a filter in this irradiation. Since the metal electrode has been already formed in the gate electrode 62, the irradiated ultraviolet ray cannot penetrate through the region where an organic semiconductor thin film 71 is to be formed, and only the photosensitive thin film corresponding to the regions of the source electrode 68, the source electrode 69, and the drain electrode 70 is exposed. After the irradiation of about 30 seconds, the photosensitive thin film is developed. By this means, the photosensitive thin film 64 corresponding to the regions of the source electrode 68, the source electrode 69, and the drain electrode 70 is removed, and the liquid repellent film 65 in each of the regions is lifted off. In this manner, the liquid repellent films 65 are formed in the regions where the organic semiconductor thin films 71 are to be formed (FIG. 2C). In the same manner as that of the gate electrode 62, the source electrode 68, the source electrode 68, and the drain electrode 70 are formed using the conductive ink (FIG. 2D). At this stage, by selectively oxidizing the source electrode 68, the source electrode 68 (silver oxide electrode) and the source electrode 69 (silver electrode) are formed. In the same manner as described above, alkyl-fluoride-based silane coupling agent is spin-coated to form a liquid repellent film 67 (FIG. 2D). By removing the photosensitive film 64 by the use of the agent for the photosensitive film 64, the liquid repellent film 65 is lifted off, and the regions other than that where the organic semiconductor thin film 71 is to be formed, that is, only the regions 67 corresponding to the source electrode 68, the source electrode 69, and the drain electrode 70 develop the liquid repellency as shown in FIG. 2E. In this embodiment, acetone is used as the agent for the photosensitive thin film.

Next, in order to form a channel, the organic semiconductor thin film 71 is coated. The solution for the organic semiconductor thin film 71 is supplied to the channel under the nitrogen atmosphere by using a supply system provided with a nozzle position control mechanism, a solution ejection amount control mechanism, and a solution heating mechanism. In this embodiment, as described in the Non-Patent Document 5, the solution in which trichlorobenzene is used as solvent and pentacene of 0.1 wt% is diffused and then dissolved by heating it to 200°C is used. This solution of about 3 microliters is supplied through a nozzle. In order to prevent the crystal growth in the solution due to the rapid temperature decrease of the solution, it is preferable to heat the substrate to about 170°C. The supplied solution is dried, and the organic semiconductor thin film 71 is formed on the upper surface as shown in FIG. 2F. In this manner, the organic semiconductor thin film 71 is formed in the lyophilic regions, and the CTFT having plasticity can be fabricated through the inexpensive method using the printing process and the coating process but not using lithography.

In this embodiment, polyimide is used for the substrate and PMMA is used for the insulating film. However, there is no problem if various types of plastic substrate such as polyvinyl are used for the substrate and polyimide, polyvinyl phenol, and others are used for the insulating film. Also, in the case where the plasticity is not required, by using an inorganic insulating film for the substrate, the advantage that the options of fabrication processes such as printing and coating are increased can be obtained. After forming a gate electrode, an insulating film is formed by Spin-On-Glass (SOG), and after a positive resist is spin-coated, the ultraviolet ray is irradiated from the rear surface by using a mercury lamp. Since the resist in the region other than that covered with the gate electrode is dissolved and removed by the development, the resist pattern has the same pattern as that of the gate electrode. In this state, alkyl-fluoride-based silane coupling agent is spin-coated. Subsequently, the alkyl-fluoride-based silane coupling agent is lifted off by removing the resist by using acetone and others, thereby forming a desired liquid repellent pattern. In this method, the heat treatment of about 450°C is required for the baking of the SOG and the organic solvent is used for the removal of the resist. Therefore, this method cannot be used when an organic material is used for the substrate and others. This method has such advantages that the number of steps of the manufacturing process is reduced and the metal is not required for forming the liquid repellent film.

(Fourth Embodiment)

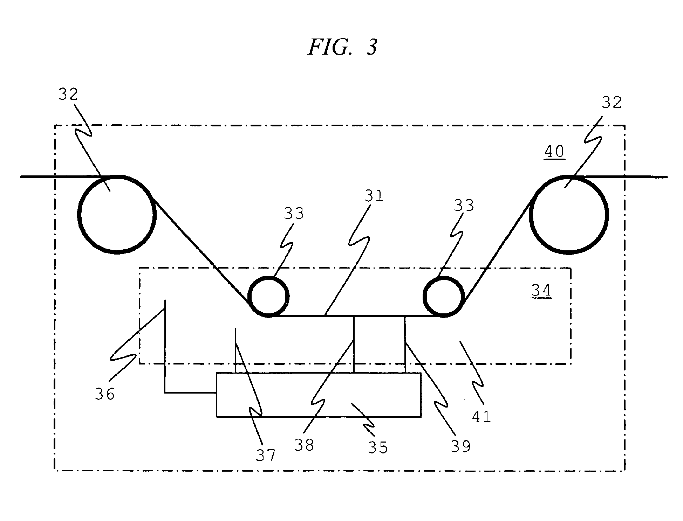

In this embodiment, a schematic example of a part of a manufacturing apparatus for successively performing the surface treatment of the electrodes for the CTFT in the present invention will be disclosed. FIG. 3 is a diagram showing a part of a manufacturing apparatus for successively performing the surface treatment of the electrodes for the CTFT according to the present invention. A chamber 40 is filled with, for example, dried nitrogen in order to maintain the atmosphere of the overall apparatus. However, it is not always necessary depending on the characteristics of organic semiconductor and electrode materials to be used. Source electrodes and drain electrodes for an n channel FET and a p channel FET are formed on the substrate 31, and a flexible substrate with plasticity is used for the substrate 31. The substrate 31 is conveyed by the rotation of substrate lead rollers 32 and 33 (roll-out side) and rolled up by the rotation of substrate lead rollers 32 and 33 (roll-up side). Manufacturing apparatus other than that for the electrode surface treatment can be provided in series in front of and at the back of the chamber 40. In the solution container 34, the substrate 31 is led by the substrate lead roller 33 and soaked into an oxidation-reduction solution 41. At this time, the surface treatment of the source electrodes of the n channel FET and the p channel FET is performed by a potentiostat 35 in the following manner. The potentiostat 35 has a reference electrode 36, a work electrode 37, an oxidation-reduction electrode 38, and an oxidation-reduction electrode 39. The reference electrode 36 inputs potential (reference potential) of the oxidation-reduction solution 41 to the potentiostat 35. The potentiostat 35 controls the potentials of the work electrode 37, the oxidation-reduction electrode 38, and the oxidation-reduction electrode 39 based on the reference potential. At this time, the current flowing in the oxidation-reduction electrode 38 and the oxidation-reduction electrode 39 is also controlled, but the circuit is configured so that the current flows in the work electrode 37 as a counter electrode and the current does not flow in the reference electrode 36. In this embodiment, the oxidation-reduction electrode 38 is kept at oxidation potential and is used to oxidize the source electrode surface of the n channel FET. Meanwhile, the oxidation-reduction electrode 39 is kept at reduction potential so as not to oxidize the surface of the silver electrode to be a source electrode of the p channel FET. By this means, the surface treatment of the source electrodes of the n channel FET and the p channel FET can be performed under the controlled conditions. Therefore, the substrate 31 can be continuously conveyed and the products with stable performance can be realized at low cost.

**Claims**

1. A field effect transistor, comprising:

   a plurality of source electrodes;
   at least one drain electrode; and
   an organic semiconductor thin film,
   wherein at least one of the electrodes has oxidation characteristics or reduction characteristics.

2. The field effect transistor according to claim 1,
   wherein a complementary transistor is formed using the plurality of source electrode and the drain electrode.

3. An organic thin-film transistor,
   wherein a source electrode and a drain electrode are made of first metal, and surfaces of the electrodes are covered with a thin film with a thickness of 0.3 to 5 atomic layer made of compound of a second element and the first metal.

4. The organic thin-film transistor according to claim 3, comprising: first and second source electrodes; at least one drain electrode; and an organic semiconductor thin film,
   wherein one of the first source electrodes is made of any one of gold, silver, copper and titanium, and
   the second source electrode is made of any one of gold, silver, copper, and titanium, and a surface of the second electrode is covered with a thin film with a thickness of 0.3 to 5 atomic layer made of sulfur, oxygen, halogen element, calcium or magnesium or compound of these elements and the electrode element.

5. The organic thin-film transistor according to claim 3, comprising: first and second source electrodes; at least one drain electrode; and an organic semiconductor thin film,
   wherein the first source electrode is made of gold, silver, copper or titanium,
   the second source electrode is made of gold, silver, copper or titanium, and
   a thin film with a thickness of 0.3 to 1 molecular layer containing pentafluorobenzenethiol, perfluoroalkylthiol, trifluoromethanethiol, pentafluoroethanethiol, heptafluoropropanethiol, nonafluorobutanethiol, sodium butanethiol, sodium butanoate thiol, or sodium butanol thiol is adsorbed to an surface of the second electrode.

6. A manufacturing method of an organic transistor, comprising the steps of:

   forming first and second source electrodes, at least one drain electrode, and an organic semiconductor thin film; and
   oxidizing or reducing at least one of the electrodes by electrochemical reaction in a solution or vapor phase reaction.

7. The manufacturing method of an organic transistor according to claim 6, further comprising the step of:

   performing an adsorption process or a desorption process on a surface of at least one of the electrodes.

8. The manufacturing method of an organic transistor according to claim 6,
   wherein, by successively passing a substrate on which the electrodes are formed through a solution or vapor phase, a surface of at least one of the electrodes is processed.

## FIG. 1

FIG. 2A

FIG. 2B

FIG. 2C

FIG. 2D

FIG. 2E

FIG. 2F

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004055654 A
- JP 2004211091 A
- JP 2004128028 A

**Non-patent literature cited in the description**

- *Science,* 2004, vol. 303, 1644
- *Applied Physics Letters,* 2004, vol. 84, 3061
- *Journal of Applied Physics,* 1996, vol. 79, 2136
- *Journal of American Chemical Society,* 2002, vol. 124, 8812
- *Synthetic Metals,* 2005, vol. 153, 1
- *Japanese Journal of Applied Physics,* 2004, vol. 43, L315
- *Applied Physics,* 2005, vol. 74 (9), 1196
- *Physical Review Letters,* 2000, vol. 84 (26), 6078